# EUROPEAN PATENT SPECIFICATION

(11) **EP 0 556 615 B1**
(45) Date of publication and mention of the grant of the patent: **28.10.1998**
(21) Application number: 93101303.1
(22) Date of filing: 28.01.1993
(51) Int. Cl.: C23C 16/26

(54) **Method of making synthetic diamond**
Verfahren zur Herstellung von synthetischen Diamanten
Méthode pour la fabrication de diamants synthétiques

(30) Priority: 17.02.1992 CA 2061302
(43) Date of publication of application: 25.08.1993
(73) Proprietor: NORTON COMPANY, Worcester, MA 01615-0008 (US)
(72) Inventor: Hansen, Jeffrey S., West Jordan, Utah 84088 (US); Hoggings, James T., Plano, Texas 75025 (US)
(74) Representative: Diehl, Hermann O. Th., Dr.

(56) References cited:
- EP-A- 0 259 791
- EP-A- 0 376 694
- EP-A- 0 518 591
- CHEMICAL ABSTRACTS, vol. 110, no. 24, Columbus, Ohio, US; abstract no. 217329P, JOFFREAU P-0 ET AL 'Low-pressure diamond growth on refractory metals'

## Description

This invention relates to a method of making synthetic diamond film.

Diamond has a number of properties which make it attractive for use as window material, free-standing domes, or other planar and non-planar structures for various applications. Among these properties are extreme hardness and excellent transmissivity of certain radiation. Diamond is also an extraordinary heat conductor, thermally stable, and an electrical insulator. However, natural diamond is prohibitively expensive for applications which require any substantial size and is difficult to form into certain shapes.

In recent years, a number of techniques have been developed for depositing synthetic diamond on surfaces of various shapes to obtain a diamond film or coating on tool surfaces and devices. These techniques include so-called high-pressure high-temperature ("HPHT") methods and chemical vapor deposition ("CVD") methods. The CVD methods include plasma deposition techniques wherein, for example, plasmas of a hydrocarbon and hydrogen are obtained using electrical arcing. The resultant plasma can be focused and accelerated toward a substrate using focusing and accelerating magnets.

In order to obtain diamond films having shapes needed for particular applications, it is desirable to have substrates for diamond deposition that can be readily formed into the appropriate shapes. Graphite is such a material, and it has been proposed that synthetic diamond film be deposited, such as by chemical vapor deposition, on the surface of a graphite substrate. If necessary, the graphite can then be removed, leaving a free-standing diamond film or layer of a desired shape. Graphite can be provided that has a coefficient of thermal expansion that is relatively close to that of diamond film, and in this respect it is favorable for deposition of diamond film. However, diamond film generally does not deposit well on graphite because of crystallographic mismatch and the tendency of the deposited carbon to graphitize.

In EP-0 400 947 a metal layer which in a subsequent step is converted into a carbide layer is used as an intermediate layer between the graphic substrate and the diamond layer.

In Chemical Abstracts 110 (24), 217329 p, growing a diamond film on metal substrates is described. The authors found that using hot filament chemical vapor deposition as diamond forming method, the metals were converted to the respective metal carbides or subcarbides during diamond formation.

It is among the objects of the present invention to devise improvements in techniques for deposition of synthetic diamond film on graphite substrates.

This object is solved by the method of independent claim 1. Further advantageous features, aspects and details of the invention are evident from the dependent claims, the description, drawings and examples.

Applicant has discovered that deposition of synthetic diamond on a graphite substrate can be substantially improved by providing a thin interlayer of a metal, particularly molybdenum or tungsten. These metals have themselves been used in the prior art as substrates for the deposition of synthetic diamond by chemical vapor deposition. Reference can be made, for example, to European Patent Publication No. 0376694. In the present invention a thin layer of the metal facilitates the adherence of the synthetic diamond being deposited. Also, since the metal will not match well with the diamond from the standpoint of thermal coefficient of expansion, a thin layer of the metal is used.

The graphite substrate will preferably have relatively small pores, for example a maximum pore size less than about 10 µm. The metal layer should be continuous, free of pores, and seal off the pores of the polished graphite surface. Given these constraints, it should also be as thin as possible, preferably in the range 5 to 100 µm, to minimize thermal mismatch stress with regard to the diamond to be subsequently deposited. The most preferred thickness is about one to two times the maximum pore size. The deposited diamond film is then removed from the substrate and the metal interlayer, such as by grinding away the graphite and etching the metal.

Further features and advantages of the invention will become more readily apparent from the following detailed description when taken in conjunction with the accompanying drawings.

Fig. 1 is an operational flow diagram of the steps of an embodiment of the method of the invention.

Fig. 2 illustrates a structure made in accordance with an embodiment of the invention.

Fig. 3 is a schematic diagram of a vertical flow CVD reactor which can be used to deposit a metal layer for use in an embodiment of the method of the invention.

Fig. 4 is a schematic diagram of a bell jar CVD reactor which can be used to deposit a metal layer for use in an embodiment of the method of the invention.

Fig. 5 is a schematic diagram of a plasma jet deposition system which is utilized for CVD deposition of synthetic diamond for use in the method of the invention.

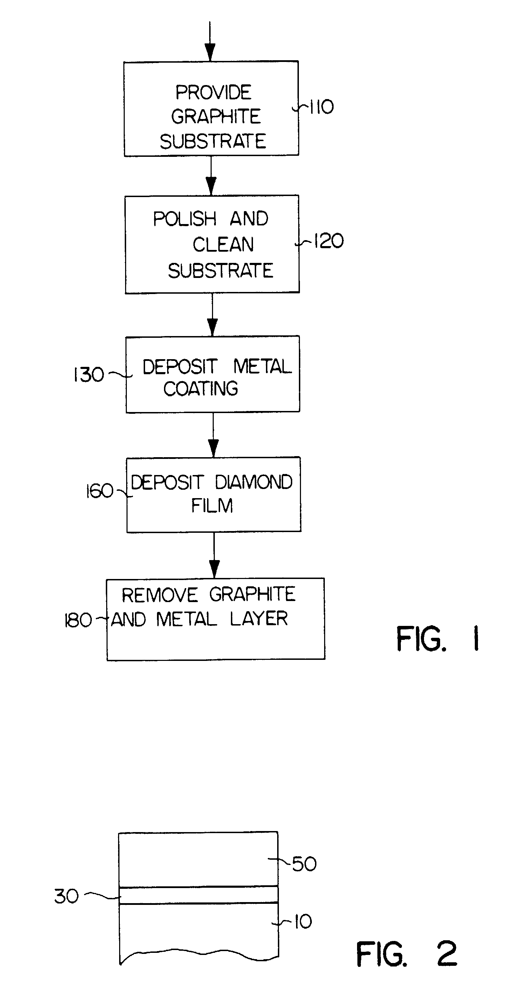

Referring to Fig. 1, there is shown, an operational flow diagram of steps that can be utilized to produce synthetic diamond film in accordance with an embodiment of the invention. The block 110 represents the providing of a graphite substrate. Preferably, the graphite material will have a relatively small pore size, for example a maximum pore size less than about 10 µm. Also, the graphite chosen should preferably have a coefficient of thermal expansion which substantially matches synthetic diamond. The graphite substrate can be machined or otherwise formed into a desired shape. The block 120 represents the polishing and cleaning of the substrate surface upon which diamond film is to be deposited. Polishing can be implemented, for example, by lapping, and the surface should preferably be polished smoother than the pore size. The polished substrate surface can then be cleaned using an ultrasonic cleaner. Next, as represented by the block 130, a metal layer is applied on the prepared graphite surface. The metal layer should be continuous, free of pores, and seal off the pores of the polished graphite surface. Given these constraints, it should also be as thin as possible, preferably in the range 5 to 100 µm, to minimize thermal mismatch stress with regard to the diamond to be subsequently deposited. The most preferred thickness is about one to two times the maximum pore size. Molybdenum and tungsten are the preferred metals for the metal layer, with molybdenum being most preferred based on work to date. The metals adhere well to graphite, and good quality synthetic diamond can be deposited on them. The metal layer can be deposited by any suitable means, for example chemical vapor deposition (CVD) or physical vapor deposition (PVD).

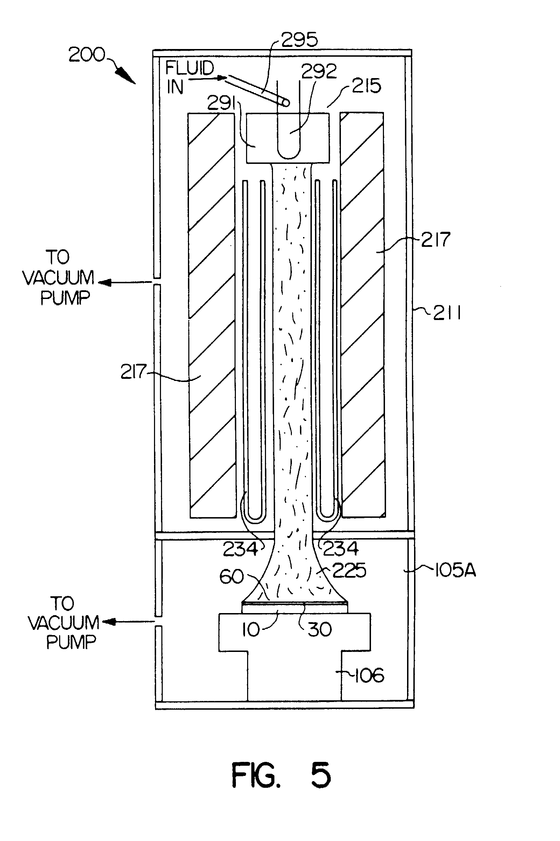

The block 160 represents the deposition of a diamond film over the metal layer. The diamond film is deposited using the plasma jet deposition technique described in conjunction with Fig. 5. The deposited diamond film is then removed from the substrate and the metal interlayer, such as by grinding away the graphite and etching the metal (block 180).

Fig. 2 illustrates the structure of a graphite substrate 10 (shown planar, although it can be any shape), the metal interlayer 30, and the synthetic diamond layer 50.

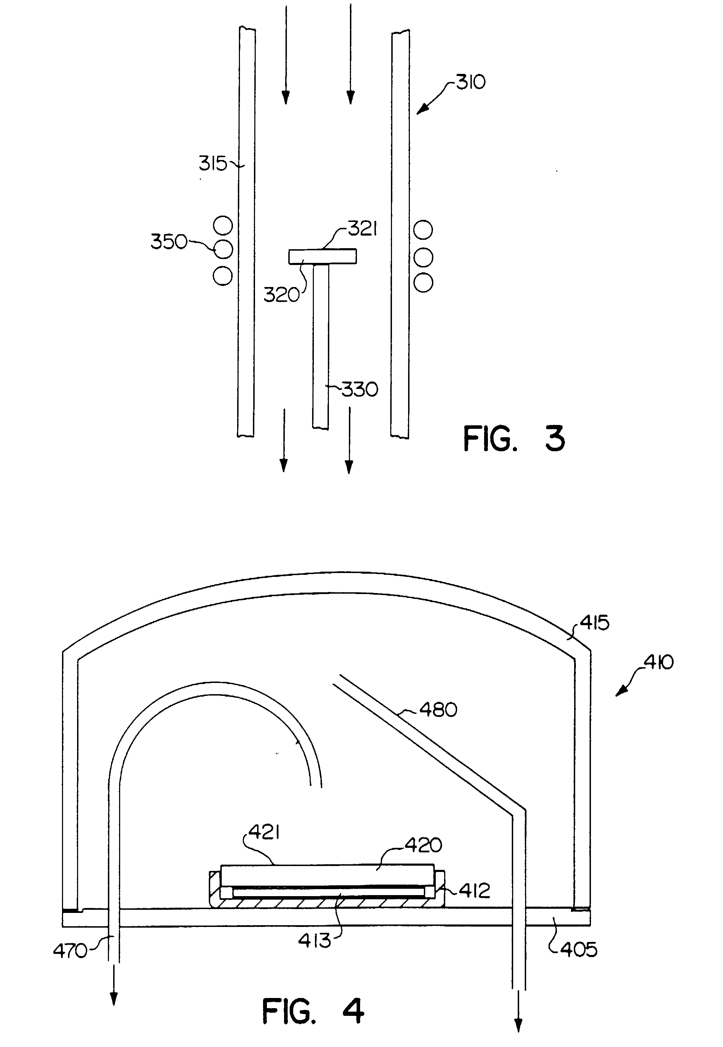

There are various ways in which the metal interlayer of the invented technique can be deposited. Fig.s 3 and 4 illustrate chemical vapor deposition (CVD) techniques. Fig. 3 shows a vertical flow CVD reactor 310 which employs a quartz tube 315 in which the graphite substrate 320 (with the prepared surface 321) is mounted on a support rod 330, that is centrally secured in the tube 315 by means not shown. An RF induction coil 350 surrounds the tube at the position of the substrate. In operation, reactant gases, for example molybdenum hexafluoride (MoF₆) and hydrogen (H₂) are fed into the tube 315 (from sources, not shown) and react on the surface 321 of the substrate 320, which is heated by the induction coil 350. The hexafluoride of the metal is reduced by the hydrogen, and the metal is deposited on the substrate surface. Exhaust gases are evacuated by a vacuum pump (not shown).

Fig. 4 illustrates another technique of CVD deposition of the metal interlayer which employs a bell jar CVD reactor 410. A base plate 405 is covered by a bell jar 415. An insulating receptacle 412 sits on the base plate 405 and contains a heating element 413, for example an electrical heating element energized by means not shown. The substrate 420, with prepared surface 421, sits on the heating element 413. A gas inlet line 470 is coupled to a source (not shown) of the supply gas which may be, for example, a carbonyl of molybdenum or tungsten. Mo(CO)₆ is used when the metal to be deposited is molybdenum. The gas line outlet is generally directed toward the substrate surface. The metal carbonyl decomposes on the hot substrate to deposit the metal coating. Exhaust gases, for example CO, are evacuated by an exhaust line 480 to a vacuum pump (not shown).

Referring to Fig. 5, there is shown a diagram of a plasma jet deposition system 200 of a type which is utilized in practicing of the invention. The system 200 is contained within a vacuum housing 211 and includes an arc-forming section 215 which comprises a cylindrical anode 291, a rod-like cathode 292, and an injector 295 mounted adjacent the cathode so as to permit injected fluid to pass over the cathode 292. In the illustrated system the input fluid may be a mixture of hydrogen and methane. The anode 291 and cathode 292 are energized by a source of electric potential (not shown), for example a DC potential. Cylindrical magnets, designated by reference numeral 217, are utilized to control the plasma generated at the arc forming section. The magnets maintain the plasma within a narrow column until the plasma reaches the deposition region 60. Cooling coils 234, in which liquid nitrogen can be circulated, are located within the magnets and surround the focused plasma.

In operation, a mixture of hydrogen and methane is fed to the injector 295, and a plasma is obtained in front of the arc forming section and accelerated and focused toward the deposition region. The temperature and pressure at the plasma formation region are typically in the approximate ranges 1500-2700 degrees C and 133-931 mbar (100-700 torr), respectively, and in the deposition region are in the approximate ranges 800-1100 degrees C and 13.3-266 mbar (10-200 torr), respectively. As is known in the art, synthetic polycrystalline diamond can be formed from the described plasma, as the carbon in the methane is selectively deposited as diamond, and the graphite which forms is dissipated by combination with the hydrogen facilitating gas.

The bottom portion 105A of the chamber has a base 106 on which can be mounted the graphite substrate 10 with the metal layer 30 on which the synthetic diamond is to be deposited. The base can include a temperature controller.

### EXAMPLE 1

A surface of a disk of CS grade graphite, as sold by Union Carbide Corp., was machined to provide a flat approximately round surface, about 5.1 cm (about 2 inches) in diameter. The maximum pore size was about 100 µm. The surface was polished using 400 grit paper, and ultrasonically cleaned. Equipment of the type shown in Fig. 3 was used to deposit molybdenum on the graphite surface, using the following deposition conditions:

| | |
|---|---|
| Pressure | 33.25 mbar (25 Torr) |
| Temperature | 900°C |
| MoF₆ flow | 25 sccm |
| H₂ flow | 250 sccm |

Deposition proceeded for 25 minutes, and the resultant molybdenum layer was about 80 µm thick. The substrate, with molybdenum coating, was then placed in equipment of the type shown in Fig. 5 for deposition of synthetic diamond using methane and hydrogen feed gases. Diamond deposition proceeded until the resultant diamond layer was about 500 µm thick. The diamond adhered and grew well on the substrate surface, and did not crack. The diamond surface was then cemented to a holding jig and the graphite substrate was ground away. The metal layer was etched away using a solution of nitric acid and hydrofluoric acid.

### EXAMPLE 2

A surface of a disk of CS grade graphite, similar to that of Example 1, was prepared in the same manner described in Example 1, and had similar characteristics. Equipment of the type shown in Fig. 4 was used to deposit molybdenum on the graphite surface using the following deposition conditions:

| | |
|---|---|
| Bell-jar pressure | 5.32 mbar (4 Torr) |
| Substrate temperature | 500°C |
| Mo(CO)₆ source temperature | 70°C |

Deposition proceeded for 30 hours, and the resultant molybdenum layer was about 15 µm thick. A synthetic diamond layer about 500 µm thick was deposited using the same equipment as in Example 1 and deposition conditions similar to those of Example 1. Again, the diamond adhered and grew well on the substrate surface and did not crack. The diamond film was then separated using the same method as in Example 1.

### EXAMPLE 3

A flat graphite plate (10.16 cm x 10.16cm x 0.635 cm) (4"x4"x1/4") was plasma sprayed with tungsten and then polished with 400 grit paper. The tungsten thickness was about 0.0076 cm (about 0.003"). Synthetic diamond was deposited using the same equipment as in Example 1. The diamond deposited well and was adherent. The graphite and tungsten were removed as described in Example 1.

## Claims

1. A method of making a diamond film, consisting essentially of the steps :
providing a graphite substrate;
depositing a metal layer on a surface of said substrate; and
depositing a synthetic diamond film on said metal layer by plasma jet deposition, and
removing said graphite substrate and said metal layer from said synthetic diamond film.

2. The method of claim 1 wherein said metal layer is a thin metal layer.

3. The method is defined by claim 1 or 2 wherein said metal layer comprises a metal selected from the group consisting of molybdenum and tungsten.

4. The method as defined by any one of the preceding claims wherein said metal layer has a thickness in the range 5 to 100 µm.

5. The method as defined by any one of the preceding claims, wherein said metal layer has a thickness of one to two times the maximum pore size of said graphite substrate.

6. The method as defined by any one of the preceding claims wherein said metal layer is deposited by a vapor deposition technique.

## Patentansprüche

1. Verfahren zur Herstellung eines Diamantfilms, das im wesentlichen aus folgenden Schritten besteht:
Bereitstellung eines Graphitsubstrats;
Ablagerung einer Metallschicht auf einer Oberfläche des Substrats; und
Ablagerung eines synthetischen Diamantfilms auf der Metallschicht durch Plasmastrahlablagerung, und
Entfernung des Graphitsubstrats und der Metallschicht von dem synthetischen Diamantfilm.

2. Verfahren gemäß Anspruch 1, bei dem die Metallschicht eine dünne Metallschicht ist.

3. Verfahren gemäß Anspruch 1 oder 2, bei dem die Metallschicht ein Metall ausgewählt aus der Gruppe bestehend aus Molybdän und Wolfram enthält.

4. Verfahren gemäß einem der vorhergehenden Ansprüche, bei dem die Metallschicht eine Dicke im Bereich von 5 bis 100 µm aufweist.

5. Verfahren gemäß einem der vorhergehenden Ansprüche, bei dem die Metallschicht eine Dicke vom Ein- bis Zweifachen der maximalen Porengröße des Graphitsubstrats aufweist.

6. Verfahren gemäß einem der vorhergehenden Ansprüche, bei dem die Metallschicht durch ein Dampfablagerungsverfahren abgelagert wird.

## Revendications

1. Procédé de fabrication d'un film en diamant, comprenant essentiellement les étapes consistant :
à prévoir un substrat en graphite ;
à déposer une couche métallique sur une surface dudit substrat ;
à déposer un film en diamant synthétique sur ladite couche métallique, au moyen d'un dépôt par projection de plasma ; et
à retirer ledit substrat en graphite et ladite couche métallique dudit film en diamant synthétique.

2. Procédé selon la revendication 1, dans lequel ladite couche métallique est une couche métallique mince.

3. Procédé selon la revendication 1 ou 2, dans lequel ladite couche métallique comprend un métal choisi dans le groupe constitué du molybdène et du tungstène.

4. Procédé selon l'une quelconque des revendications précédentes, dans lequel ladite couche métallique a une épaisseur comprise entre 5 et 100 µm.

5. Procédé selon l'une quelconque des revendications précédentes, dans lequel ladite couche métallique a une épaisseur égale à une à deux fois la taille de pore maximale dudit substrat en graphite.

6. Procédé selon l'une quelconque des revendications précédentes, dans lequel ladite couche métallique est déposée par une technique de dépôt en phase vapeur.
